# FASCICULE DE BREVET EUROPEEN

(11) **EP 2 144 369 B1**
(45) Date de publication et mention de la délivrance du brevet: **06.07.2011**
(21) Numéro de dépôt: 09164684.4
(22) Date de dépôt: 06.07.2009
(51) Int. Cl.: H03H 9/02, H03H 9/24, H03H 3/007

(54) **Résonateur à ondes de volume**
Volumenwellenresonator
Bulk acoustic wave resonator

(30) Priorité: 11.07.2008 FR 0854737
(43) Date de publication de la demande: 13.01.2010
(73) Titulaire: ST MICROELECTRONICS S.A., 92120 Montrouge (FR); Commissariat à l'Énergie Atomique et aux Énergies Alternatives, 75015 Paris (FR)
(72) Inventeur: Durand, Cédric, 38400 Saint-Martin d'Hères (FR); Casset, Fabrice, 38570 Tencin (FR)
(74) Mandataire: de Beaumont, Michel

(56) Documents cités:
- WO-A-2007/072409
- US-A- 6 035 714
- US-A1- 2007 296 527

## Description

### Domaine de l'invention

La présente demande concerne des microsystèmes électromécaniques. Plus particulièrement, la présente demande sera décrite appliquée à des structures et à des procédés de fabrication de résonateurs à ondes de volume.

### Exposé de l'art antérieur

Pour réaliser des bases de temps, de nombreux circuits utilisent des oscillateurs comprenant un quartz. De tels oscillateurs ont un facteur de qualité élevé de l'ordre de 100 000 et une fréquence de résonance stable en température. Ils présentent toutefois l'inconvénient d'avoir une plage de fréquences de résonance limitée à des valeurs inférieures à la centaine de mégahertz, typiquement 60 MHz. De plus, ils sont difficilement intégrables avec les technologies microélectroniques en raison de leurs dimensions importantes et du recours à des procédés de fabrication non compatibles avec ceux de la formation de circuits sous forme monolithique dans un substrat semiconducteur.

Pour atteindre des fréquences plus élevées et réduire les niveaux de consommation de puissance, des théoriciens ont proposé de remplacer les oscillateurs à quartz par des microsystèmes électromécaniques (MEMS) résonants parmi lesquels des résonateurs à ondes de volume (bulk mode resonators).

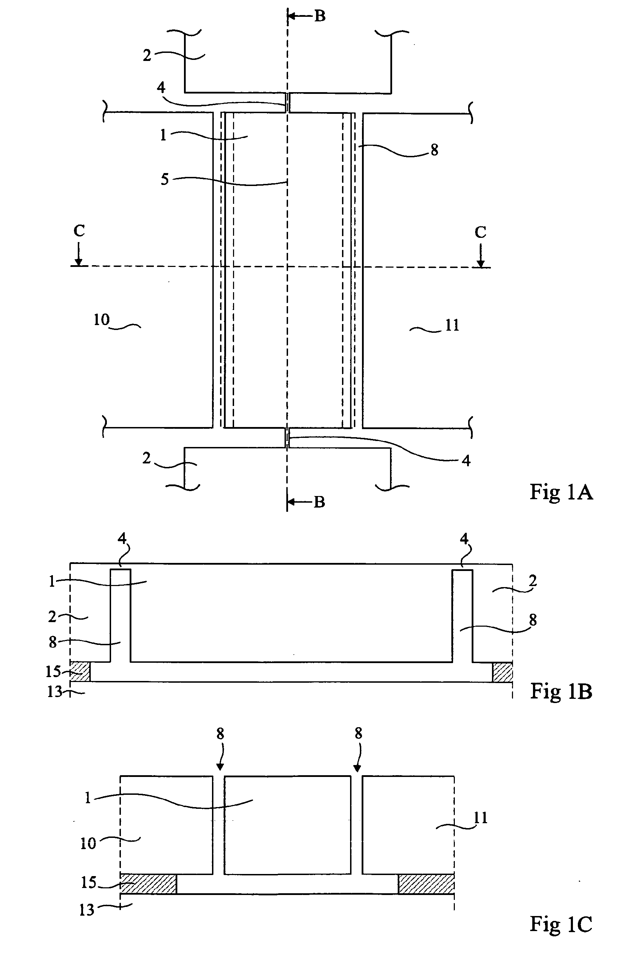

La figure 1A est une vue de dessus partielle et schématique d'un résonateur à ondes de volume. La figure 1B est une vue en coupe selon le plan B-B de la figure 1A. La figure 1C est une vue en coupe de la figure 1A selon le plan C-C.

Le résonateur comporte un élément résonant 1. L'élément 1 est constitué d'une portion d'un matériau semiconducteur monocristallin ou polycristallin en forme de barreau de section rectangulaire. L'élément 1 est fixé à au moins une zone d'ancrage 2 par des bras 4. Les bras 4 ont des dimensions minimales et sont disposés de façon à contacter l'élément 1 au niveau de noeuds de vibration de celui-ci. L'élément 1 ayant une section rectangulaire, les bras 4 sont alignés le long d'une ligne neutre de vibration 5 illustrée en traits pointillés.

En-dehors de sa liaison avec les bras 4, l'élément 1 est entouré d'un intervalle vide 8. Deux électrodes 10 et 11 sont placées symétriquement en regard de l'élément 1 de part et d'autre de la ligne neutre 5.

Comme l'illustrent les figures 1B et 1C, la structure décrite est formée dans une couche mince de silicium monocristallin reposant sur une plaquette de silicium 13 avec interposition d'une couche isolante 15. La partie de l'intervalle 8 séparant l'élément 1 du support 13 résulte du retrait partiel de l'isolant 15. L'élément 1, les ancrages 2 et les électrodes 10 et 11 sont réalisés dans la couche mince de silicium.

Le fonctionnement du résonateur est le suivant. L'élément 1 étant à un premier potentiel, les électrodes 10 et 11 sont mises à un deuxième potentiel. La différence de potentiel entre l'élément 1 et les électrodes 10 et 11 crée une force électrostatique qui provoque une déformation du réseau cristallographique de l'élément 1. L'élément 1 entre alors dans un mode de vibration en volume à sa fréquence de résonance, ce qui correspond à une oscillation d'ondes de volume autour de la ligne neutre centrale 5 de l'élément 1. La déformation de l'élément 1 provoque une variation de la capacité du condensateur constitué par l'élément 1 et les électrodes 10 et 11. Cette variation de capacité peut être détectée au niveau de l'électrode 10 ou 11.

En théorie, il est ainsi possible d'obtenir des résonateurs ayant des fréquences de résonance qui varient dans une plage allant de 10 à 300 MHz jusqu'à 1,5 à 3 GHz.

De tels résonateurs présentent les avantages théoriques d'avoir de la consommation de puissance inférieurs à ceux des oscillateurs à quartz et d'être facilement intégrables.

En pratique, l'utilisation de tels résonateurs à ondes de volume notamment en tant que bases de temps se heurte à diverses limites, en particulier leur extrême sensibilité aux variations de température.

Des résonateurs ayant des fréquences élevées supérieures à la centaine de mégahertz sont particulièrement recherchés pour des bases de temps placées dans des appareils portables tels que des téléphones ou des ordinateurs. Dans de tels appareils, l'accroissement de température en fonctionnement peut être important. Des normes fixent une valeur maximale du coefficient de température de la fréquence (TCf) de seulement quelques parties par million par degré Celsius (ppm/°C).

Pour les matériaux semiconducteurs constituant l'élément résonant 1, la fréquence de résonance présente un coefficient de température TCf qui est négatif et a une valeur absolue largement supérieure aux limites fixées par la norme. Ainsi, pour le silicium, la fréquence a un coefficient de température TCf compris entre -12 et -30 ppm/°C.

### Résumé de l'invention

La présente invention vise à proposer des structures de résonateurs à ondes de volume et des procédés de fabrication de ceux-ci qui pallient les inconvénients des dispositifs connus.

En particulier, la présente invention vise à proposer des résonateurs à ondes de volume dont la fréquence d'oscillation a un coefficient de température limité à quelques ppm/°C.

La présente invention vise également à proposer des résonateurs à ondes de volume à coefficient de température positif.

Un mode de réalisation de la présente invention prévoit un résonateur comprenant un élément résonant comportant un corps et des colonnes d'un matériau ayant un module d'Young dont le coefficient de température est d'un signe opposé à celui du corps.

Selon l'invention, on entend par résonateur d'une façon large tout microsystème comportant un élément déformable.

Selon un mode de réalisation de la présente invention, le résonateur est un résonateur à ondes de volume.

Selon un mode de réalisation de la présente invention, les colonnes s'étendent orthogonalement à la direction de vibration des ondes de volume.

Selon un mode de réalisation de la présente invention, les colonnes sont réparties dans l'élément selon la ou les directions d'extension/compression de l'élément.

Selon un mode de réalisation de la présente invention, une partie centrale de l'élément est dépourvue de colonnes.

Selon un mode de réalisation de la présente invention, une partie périphérique de l'élément est dépourvue de colonnes.

Selon un mode de réalisation de la présente invention, les colonnes sont présentes dans l'élément dans une proportion comprise entre 10 et 60 % en volume.

Selon un mode de réalisation de la présente invention, les colonnes sont présentes dans l'élément dans une proportion de 40 % en volume.

Selon un mode de réalisation de la présente invention, le corps est en silicium, en silicium-germanium, en arséniure de gallium, en carbure de silicium ou en carbone diamant.

Selon un mode de réalisation de la présente invention, le matériau constituant les colonnes est de l'oxyde de silicium, de l'oxyde d'aluminium ou un oxynitrure de silicium.

La présente invention prévoit également un procédé de formation d'un résonateur dans un substrat, comprenant une étape de formation, dans une partie du substrat destinée à constituer un élément résonant, de colonnes en un matériau dont le module d'Young a un coefficient de température du signe opposé à celui du substrat.

Selon un mode de réalisation de la présente invention, la formation des colonnes comprend successivement :
former des ouvertures dans toute l'épaisseur de la partie du substrat destinée à constituer l'élément résonant ; et
déposer dans les ouvertures un matériau ayant un coefficient de température du module d'Young du signe opposé à celui du matériau constituant le substrat.

Selon un mode de réalisation de la présente invention, le substrat est un substrat sur isolant et sont déposées :
avant le dépôt du matériau ayant un coefficient de température du module d'Young du signe opposé à celui du matériau constituant le substrat, au moins au fond des ouvertures, une couche mince d'un premier matériau gravable sélectivement par rapport à l'isolant du substrat sur isolant ; et
après le dépôt dans les ouvertures du matériau ayant un coefficient de température du module d'Young du signe opposé à celui du matériau constituant le substrat, une couche d'un second matériau gravable sélectivement par rapport audit isolant du substrat sur isolant.

### Brève description des dessins

Ces objets, caractéristiques et avantages, ainsi que d'autres seront exposés en détail dans la description suivante d'exemples de réalisation particuliers faite à titre non-limitatif en relation avec les figures jointes parmi lesquelles :
les figures 1A, 1B et 1C illustrent un résonateur à ondes de volume connu ;
la figure 2A illustre, en vue de dessus schématique et partielle, un résonateur à ondes de volume selon un mode de réalisation de la présente invention ;
les figures 2B, 2C et 2D sont des vues en coupe de la figure 2A selon des plans B-B, C-C et D-D respectivement ;
la figure 3 est une vue de dessus illustrant un résonateur à ondes de volume selon un autre mode de réalisation de la présente invention ;
la figure 4 est une vue de dessus illustrant un résonateur à ondes de volume selon un autre mode de réalisation de la présente invention ; et
les figures 5A à 5F sont des vues en coupe partielle et schématique qui illustrent des étapes successives d'un procédé de fabrication d'un résonateur à ondes de volume selon un mode de réalisation de la présente invention.

Par souci de clarté, comme cela est habituel dans la représentation des microsystèmes, les diverses figures ne sont pas tracées à l'échelle.

### Description détaillée

Pour pallier la chute importante de la fréquence d'un résonateur à ondes de volume quand la température augmente, diverses solutions ont été proposées.

Une solution consiste à modifier la forme de l'élément 1 en lui conférant par exemple une forme de diapason, de plaque ou encore de disque. Toutefois, une modification de forme a un effet limité et ne permet pas de réduire ou limiter le coefficient de température TCf de façon suffisante pour pouvoir assurer un fonctionnement à une fréquence élevée stable lorsque la température varie.

La demande de brevet américain 2004/0207489 décrit une autre solution basée sur le fait que, la fréquence de résonance de l'élément résonant étant une fonction de la racine carrée de son module d'Young E, le coefficient de température TCf est une fonction du coefficient de température TCE du module d'Young E. Pour compenser les effets de variation de la fréquence avec la température, ce document propose d'enrober l'élément résonant d'un matériau dont le module d'Young a un coefficient de température TCE de signe opposé à celui du matériau constituant l'élément résonant. Ainsi, un élément de silicium est enrobé d'une gaine d'oxyde de silicium qui présente un coefficient de température TCE positif.

Cette solution se heurte toutefois à la quantité importante d'oxyde de silicium dont il faut enrober l'élément pour obtenir un matériau composite global dont le coefficient TCf soit nul ou négatif de seulement quelques ppm/°C. Ainsi, les inventeurs ont établi que pour satisfaire à la condition voulue d'un coefficient de température TCf global de l'ordre de -0,2 ppm/°C dans une plage de température allant de -15 à +85°C pour un élément résonant de silicium monocristallin en forme de barreau de section rectangulaire semblable à celui des figures 1A-C, d'une épaisseur de 3 µm pour une largeur de 42 µm et ayant une fréquence de résonance de l'ordre de 100 MHz, il faut enrober l'élément résonant d'un épaisseur d'oxyde comprise entre 1,5 et 2 µm. La réalisation d'une telle épaisseur d'oxyde pose de nombreux problèmes de fabrication. En outre, une telle gaine perturbe fortement la vibration de l'élément et sa détection. En effet, compte-tenu de son épaisseur importante, la gaine devient l'isolant majoritaire du condensateur virtuel entre l'élément résonant et les électrodes. La gaine constitue un isolant entre les électrodes et l'élément ce qui diminue fortement les effets de transduction électromécanique, rendant la détection électrostatique très difficile, voire impossible.

D'autres solutions consistent à effectuer une correction électronique de la fréquence, notamment au moyen de boucles à verrouillage de phase. Ces solutions sont trop encombrantes et consommatrices de puissance pour pouvoir être mises en oeuvre dans des dispositifs portables alimentés par des batteries. En outre, elles apportent souvent un bruit de phase de l'oscillateur hors norme qui en interdit l'utilisation.

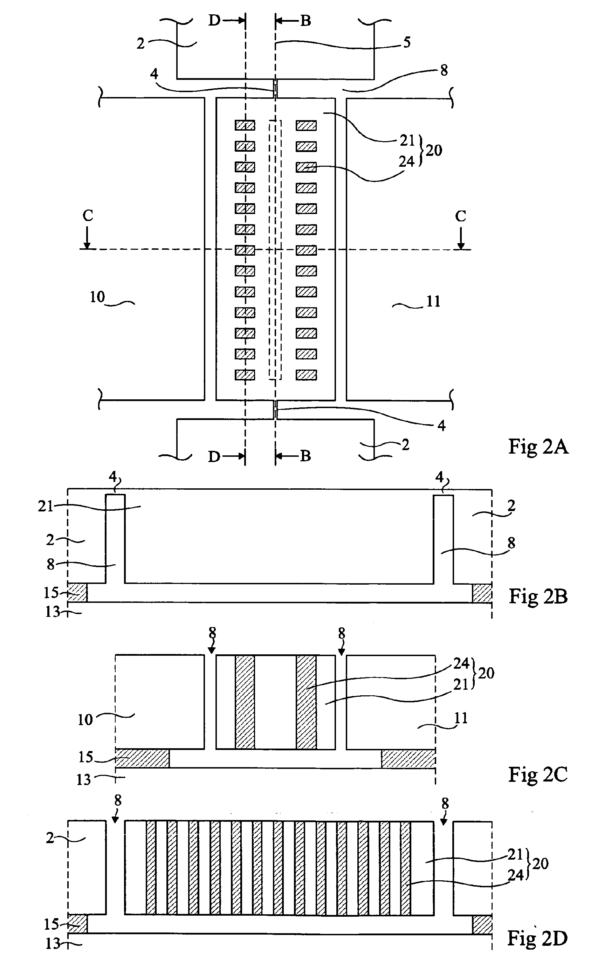

La figure 2A illustre en vue de dessus partielle et schématique un résonateur à ondes de volume proposé ici. Les figures 2B, 2C et 2D sont des vues en coupe respectivement selon les plans B-B, C-C et D-D de la figure 2A. Ce résonateur comprend un élément vibrant 20 porté par des bras 4 entre des zones d'ancrage 2. Cet élément est susceptible de vibrer en volume de part et d'autre d'une ligne neutre 5 et est disposé entre des électrodes 10 et 11, de façon similaire à ce qui a été décrit en relation avec les figures 1A à 1C.

Comme l'illustrent les figures 2A à 2D, l'élément vibrant 20 comporte un corps en matériau semiconducteur monocristallin 21 traversé par des colonnes 24 d'un matériau dont le module d'Young E présente un coefficient de température TCE opposé à celui du corps semiconducteur 21. Par exemple, en supposant que le corps 21 est du silicium monocristallin dont le module d'Young a un coefficient de température TCE de l'ordre de -67,5 ppm/°C, les colonnes 24 sont constituées au moins partiellement d'oxyde de silicium (SiO₂) ayant un coefficient de température TCE de l'ordre de +185 ppm/°C.

Comme l'illustrent les figures 2C et 2D, les colonnes 24 s'étendent sur toute l'épaisseur du corps 21 orthogonalement à la direction de propagation des ondes de volume.

Les colonnes 24 sont de préférence réparties régulièrement dans l'élément 20 à l'exclusion d'une portion centrale disposée autour de la ligne neutre et d'une portion périphérique de l'élément 20, de façon qu'entre deux colonnes 24 se trouve une portion continue du corps 21 allant d'un bout à l'autre de l'élément 20 dans sa direction d'extension/compression.

Ainsi, comme l'illustre la figure 2A, vue en coupe selon la ligne neutre B-B, la structure du résonateur n'est pas modifiée par rapport au résonateur des figures 1A à 1C. Pour un élément 20 d'une largeur de l'ordre de 40 µm, les colonnes 24 sont exclues d'une portion centrale rectangulaire d'une largeur d'environ 1 µm centrée sur la ligne neutre 5. La zone d'exclusion périphérique d'une largeur d'environ 1 µm est illustrée dans les figures 2A, 2C et 2D. Cette zone périphérique est maintenue libre de colonnes pour permettre d'assurer une continuité électrique et mécanique sur les bords de l'élément résonant.

Les colonnes 24 peuvent avoir en vue de dessus une forme régulière par exemple une forme circulaire, carrée ou de losange.

Les colonnes 24 peuvent également avoir en vue de dessus une section dont une des dimensions est plus grande qu'une autre, par exemple une forme elliptique ou, comme l'illustre la figure 2A, une forme rectangulaire. Dans ce cas, les colonnes 24 sont disposées de façon que la plus grande dimension de leur section soit orientée dans la direction de propagation des ondes de volume.

Les colonnes 24 ont une largeur d'au plus 1 µm, de préférence de 300 à 700 nm, par exemple d'environ 500 nm.

Des colonnes 24 allongées peuvent être remplacées par une succession de sous-colonnes ayant les dimensions les plus petites possibles.

La proportion de colonnes 24 par rapport au corps 21 dans l'élément 20 est comprise entre 10 et 60 %, par exemple de 40 %.

La largeur de l'élément 20 varie en fonction de la fréquence de résonance recherchée. Ainsi, pour une fréquence de l'ordre de 10 MHz, l'élément 20 aura une largeur de l'ordre de 100 µm et, pour une fréquence de l'ordre du gigahertz, une largeur d'environ 10 µm. Les dimensions des zones d'exclusion périphérique et centrale varient alors entre 1,5 µm et 0,5 µm.

Les inventeurs ont montré qu'un résonateur à ondes de volume dont l'élément vibrant 20 comporte des colonnes 24 noyées dans un corps semiconducteur 21, les colonnes 24 étant en un matériau présentant un coefficient TCE du signe opposé à celui du corps 21 se comporte comme un matériau composite ayant un coefficient TCE égal à la combinaison des coefficients TCE des deux matériaux pondérés par leurs proportions volumiques respectives.

Il est ainsi possible d'ajuster le coefficient de température TCf de la fréquence à une valeur inférieure à quelques ppm/°C. De façon très avantageuse, la présente invention permet également d'obtenir des résonateurs ayant un coefficient TCf positif. Alors, lorsque la température augmente, la fréquence augmente également. L'augmentation de la fréquence induit un raccourcissement des temps nécessaires à une opération, donc du temps de fonctionnement, ce qui réduit les risques d'échauffement.

En outre, l'épaisseur déposée du matériau des colonnes 24 est limitée à au plus la demi-largeur des colonnes 24, ce qui réduit les coûts de fabrication.

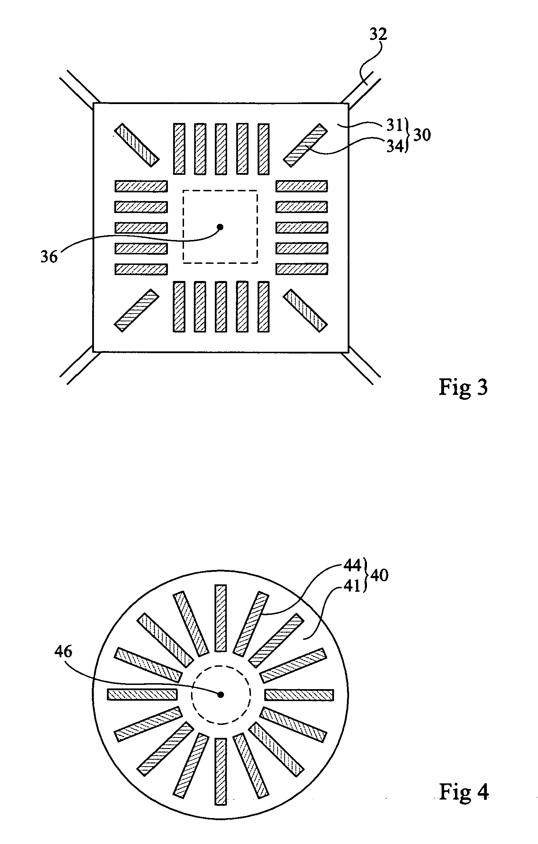

La réalisation de telles colonnes n'est pas limitée à une forme particulière de résonateur. Ainsi, les figures 3 et 4 illustrent d'autres modes de réalisation de l'invention.

La figure 3 est une vue de dessus d'un résonateur à ondes de volume comportant un élément résonant 30 en forme de plaque carrée. La plaque 30 est constituée d'un corps 31 en un matériau semiconducteur monocristallin fixé à des ancrages non représentés par des bras 32 qui partent du corps 31 au niveau des noeuds de vibration constitués par les quatre coins de la plaque 30.

Des colonnes 34 sont formées dans toute l'épaisseur de la plaque 30. De préférence, les colonnes 34 s'étendent radialement selon la direction d'extension/compression de l'élément 30.

Les colonnes 34 sont régulièrement réparties dans une zone comprise entre des zones d'exclusion centrale et périphérique centrées sur le noeud de vibration constitué par le centre géométrique 36 de la plaque 30.

Les dimensions de la plaque 30 varient en fonction de la fréquence de résonance recherchée. Ainsi, la plaque 30 a un côté allant de 500 µm pour une fréquence de l'ordre de 10 MHz jusqu'à 5 à 10 µm pour une fréquence de l'ordre du gigahertz. La largeur des zones d'exclusion varie de 1 à 2 µm pour une fréquence de la dizaine de mégahertz jusqu'à 0,2 à 0,5 µm pour des fréquences de l'ordre du gigahertz. Par exemple, pour une plaque 30 de 30 µm de côté pour une fréquence de l'ordre de la centaine de mégahertz, les zones d'exclusion ont une largeur de l'ordre de 1 à 1,5 µm.

La figure 4 illustre en vue de dessus un résonateur à ondes de volume selon un autre mode de réalisation de l'invention. Le résonateur comporte un élément résonant 40 en forme de disque constitué d'un corps semiconducteur monocristallin 41 dans lequel sont noyées des colonnes 44. Les colonnes 44 sont réparties autour du noeud constitué par le centre 46 du disque. Les colonnes 44 sont disposées de façon que leur dimension principale en vue de dessus soit parallèle à la direction de propagation des ondes de volume. De façon similaire aux modes de réalisation des figures 2 et 3, autour du noeud central 46 s'étend une zone d'exclusion dans laquelle aucune colonne 44 n'est formée. De même, les colonnes 44 sont exclues d'une zone périphérique.

Ainsi, le résonateur peut comporter un élément ayant des formes très variées. L'homme de l'art saura adapter la position des colonnes selon ce qui a été décrit précédemment de façon qu'elles s'étendent, en dehors de zones d'exclusion centrale et périphérique, symétriquement autour d'un noeud central de vibration. De préférence, les colonnes 34 s'étendent radialement selon la direction de propagation des ondes de volume.

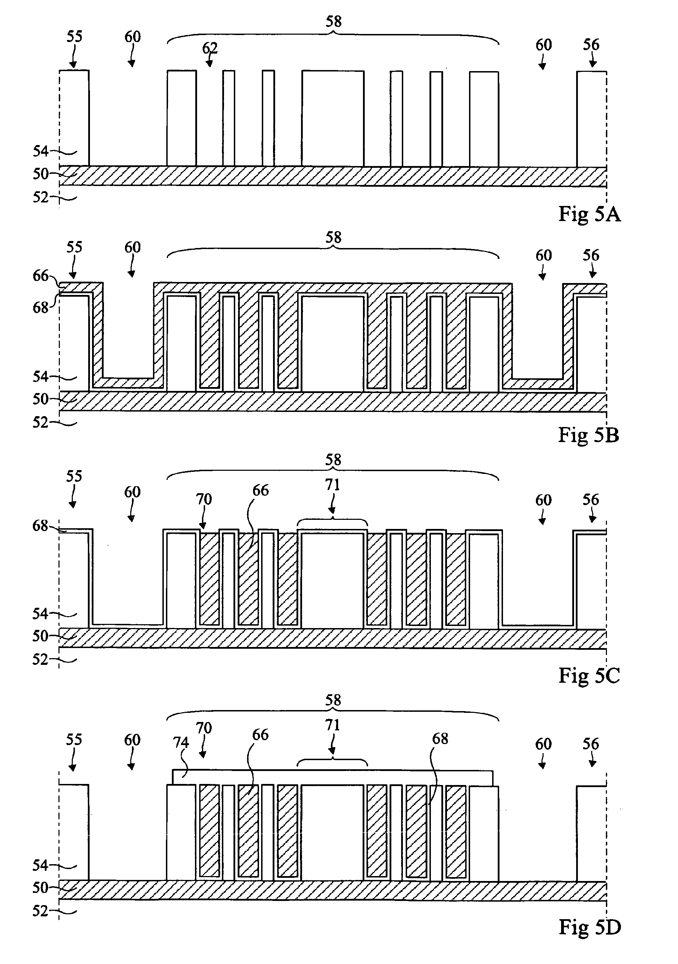

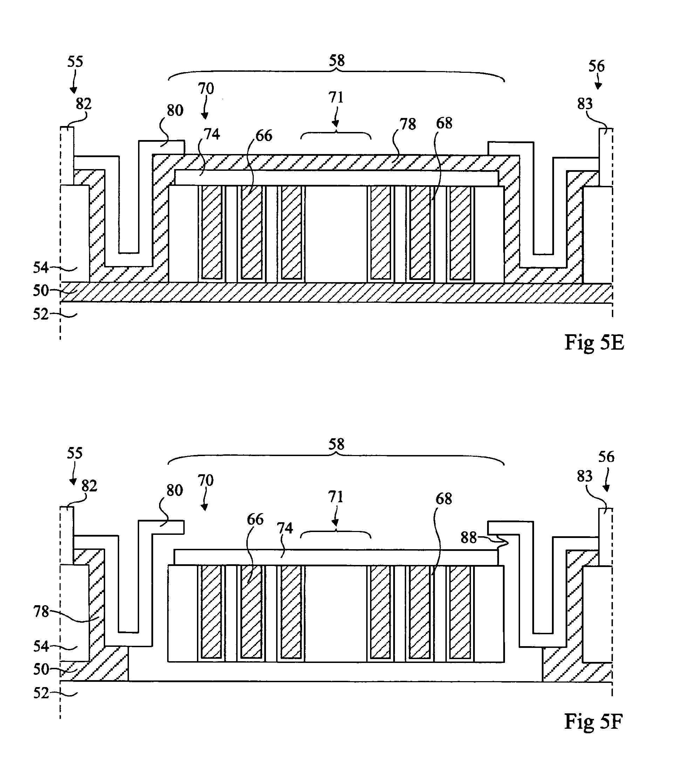

Les figures 5A à 5F sont des vues en coupe qui illustrent à titre d'exemple différentes étapes d'un procédé de fabrication d'un résonateur à ondes de volume similaire à celui des figures 2A à 2D. Les figures 5A et 5F sont des vues selon un plan de coupe correspondant au plan C-C de la figure 2A.

On part d'une tranche semiconductrice du type silicium sur isolant dans laquelle un isolant 50 sépare une plaquette 52 d'un matériau semiconducteur d'une couche mince monocristalline du même matériau semiconducteur ou d'un autre matériau semiconducteur 54.

Comme l'illustre la figure 5A, on commence par définir dans la couche 54 les contours de zones d'ancrage (non représentées), d'un élément résonant 58 et d'électrodes 55 et 56, en creusant des tranchées 60. Lors de cette étape, on creuse également des ouvertures 62 aux emplacements où l'on souhaite former des colonnes selon la présente invention. Les tranchées 60 et les ouvertures 62 sont formées dans toute l'épaisseur de la couche 54. Les tranchées 60 et les ouvertures 62 peuvent être formées en utilisant un même masque ou deux masques successifs.

Aux étapes suivantes illustrées en figure 5B, on dépose au moins une couche d'un matériau 66 dont le module d'Young E a un coefficient de température TCE du signe opposé à celui du matériau constituant la couche 54.

Avant le dépôt du matériau 66, on peut déposer une couche mince d'un matériau 68 propre à ne pas être affectée par une gravure de l'isolant 50. La couche 68 n'est prévue que lorsque le matériau 50 n'est pas gravable sélectivement par rapport au matériau 66, en particulier quand le matériau 66 est identique à l'isolant 50, par exemple de l'oxyde de silicium. Selon une variante non représentée, la couche est déposée uniquement au fond des ouvertures 62.

Aux étapes suivantes illustrées en figure 5C, le matériau 66 est retiré dans les tranchées 60 et sur toutes les surfaces planes de la couche 54. Le matériau 66 n'est maintenu en place que dans les ouvertures 62 de la figure 5A qu'il remplit complètement, formant des colonnes 70. Par rapport au résonateur vu de dessus en figure 2A et en coupe en figure 2C, on notera que les colonnes 70 sont réparties de part et d'autre d'une région centrale 71 dépourvue de colonnes et que de, part et d'autre de cette région d'exclusion 71, chaque colonne allongée 24 de la figure 2 est remplacée par trois colonnes 70 alignées.

Aux étapes suivantes illustrées en figure 5D, on dépose une couche mince 74 d'un matériau gravable sélectivement par rapport aux matériaux constituant l'isolant 50 et les colonnes 70. De préférence, la couche 74 est en un même matériau que la couche 68. La couche 74 est gravée de façon à n'être maintenue en place qu'au-dessus des colonnes 70. La couche 68 est ensuite retirée des tranchées 60 et de toutes les surfaces non protégées par la couche 74. De préférence, la couche 74 est de même nature que la couche 68 et la couche 68 est retirée en même temps que la couche 74 est gravée.

Le procédé se poursuit ensuite par des étapes de formation des électrodes du résonateur avec réservation d'un intervalle entre les électrodes 55 et 56 et l'élément 58 ainsi que la formation de contacts d'électrode.

Pour ce faire, comme l'illustre la figure 5E, on dépose de façon conforme une couche sacrificielle 78 d'une épaisseur égale à la largeur que l'on souhaite conférer à l'intervalle séparant les électrodes 55 et 56 de l'élément résonant 58. De préférence, pour simplifier le procédé de libération de l'élément 58, la couche 78 est une couche de même nature que la couche 50. Ensuite, une couche conductrice 80 est déposée. La couche 80 est gravée de façon à être retirée de l'aplomb de la surface supérieure de l'élément 58.

La couche 80 peut surplomber une faible partie périphérique de l'élément 58.

Au niveau des électrodes 55 et 56, la couche 80 et la couche 78 sont ouvertes de façon à former des contacts d'électrode 82 et 83 par dépôt et gravure d'une couche conductrice, de préférence métallique.

Aux étapes suivantes illustrées en figure 5F, les couches 78 et 50 sont retirées. De préférence, les couches 78 et 50 sont en un même matériau et sont retirées par un même procédé. Le retrait de l'isolant 50 et de la couche 78 permet de libérer l'élément résonant 58 du résonateur. Lors de ce retrait, l'isolant enterré 50 peut être retiré au moins partiellement sous l'électrode 80 ce qui est sans effet sur le fonctionnement du dispositif. Le retrait de la couche 78 permet d'assurer la formation de l'intervalle 88 dans lequel l'élément 58 peut vibrer à proximité des électrodes. La présence au fond des colonnes 70 de la couche 68 et de la couche 74 sur les colonnes 70 permet de protéger le matériau 66 des colonnes 70 pendant cette étape de libération de l'élément 58. La nature de la couche 74 et/ou son épaisseur sont choisies de façon à protéger le matériau 66 constituant les colonnes 70 pendant le retrait de la couche 78.

Un avantage du procédé de fabrication décrit est qu'il utilise un substrat sur isolant SOI standard dans lequel l'épaisseur de l'isolant 50 est comprise entre 100 nm et 3 µm, typiquement de l'ordre de 1 µm. De même, toutes les couches utilisées présentent des dimensions compatibles avec les filières technologiques standard. En particulier, pour obtenir une stabilisation équivalente du coefficient TCf, le procédé proposé par la demande américaine 2004/0207489 imposerait une gaine d'une épaisseur de quatre à dix fois supérieure.

A titre d'exemple, les dimensions et natures des différentes couches sont les suivantes.
- La plaquette 52 est une plaquette de silicium monocristallin, par exemple d'une épaisseur comprise entre 300 et 750 µm, par exemple de 750 µm.
- L'isolant 50 est une couche d'oxyde de silicium d'une épaisseur comprise entre 100 nm et 3 µm, par exemple de 1 µm.
- La couche 54 est une couche de silicium monocristallin d'une épaisseur comprise entre 1 et 20 µm, par exemple de 3 µm.
- les tranchées 60 ont une largeur qui est minimisée en fonction du double de la somme des moitiés des épaisseurs des couches 78 et 80.
- Les ouvertures 62 ont une largeur ou un diamètre d'au plus 1 µm. De préférence, la largeur des ouvertures est réduite à la valeur minimale possible en fonction des procédés de gravure de la couche 54.
- Le matériau 66 constituant les colonnes 70 présente un coefficient de température TCE du module d'Young E du signe opposé à celui du matériau constituant la couche 54. Par exemple, si la couche 54 est du silicium ayant à 30°C un module d'Young de 165,6 GPa et un coefficient TCE de l'ordre de -67,5 ppm/°C, le matériau 66 est une couche d'oxyde de silicium d'un module E de 73 GPa et de coefficient TCE de +185 ppm/°C. Le matériau 66 peut également être de l'oxyde d'aluminium (Al₂O₃) ou un oxynitrure de silicium (SiON).
- La couche de protection 68 est une couche d'une épaisseur pouvant aller de quelques nanomètres à quelques dizaines de nanomètres d'un matériau présentant des caractéristiques de gravure très sélectives par rapport à l'isolant 50 et à la couche 78. Son épaisseur est très faible par rapport à celle du matériau 66 constituant les colonnes 70 afin de ne pas perturber le comportement de l'élément résonant 58 et notamment pour ne pas influer sur la fréquence de résonance, ni sur les coefficients de température TCf et TCE. Par exemple, si l'isolant 50 et la couche 78 sont en oxyde de silicium, le matériau 68 peut être une couche de silicium monocristallin ou polycristallin ou une couche isolante par exemple une couche de nitrure de silicium (Si₃N₄), une couche d'oxyde d'hafnium (HfO₂) une couche d'oxyde d'un alliage d'hafnium et de zirconium (HfZrO₂), une couche d'un oxyde d'aluminium (Al₂O₃), une couche de nitrure de titane (TiN), une couche de nitrure de tantale (TaN) ou encore une couche d'un oxyde de tantale (Ta₂O₅).
- La couche de protection 74 est une couche d'un matériau présentant des caractéristiques de gravure très sélectives par rapport à l'isolant 50 et à la couche 78. La couche 74 est choisie parmi les mêmes matériaux que la couche 68. De préférence, le matériau constituant la couche 74 est identique au matériau de la couche 68. La couche 74 a une épaisseur de quelques dizaines de nanomètres. Comme pour la couche 68, cette épaisseur est minimisée pour ne pas influencer le comportement de l'élément 58, notamment pour que seuls le corps 54 et le matériau 66 constituant les colonnes 70 influent sur ses coefficients de température TCE et TCf. Selon une variante, pour minimiser ses effets, la couche 74 n'est pas une couche continue mais est retirée à l'étape de la figure 5D de façon à ne laisser en place qu'un bouchon individuel à l'aplomb de chaque colonne 70.
- La couche sacrificielle 78 a une épaisseur comprise entre 20 et 500 nm. Il s'agit par exemple d'une couche d'oxyde de silicium.

On a considéré que les couches de protection 68 et 74 n'étaient pas attaquées pendant le retrait de l'isolant 50 et de la couche sacrificielle 78. Toutefois, selon une variante, leurs nature et épaisseur sont choisies en fonction des matériaux constituant l'isolant 50 et la couche 78 et de mode de gravure de ceux-ci de façon que leur vitesse de gravure soit beaucoup plus lente. Ainsi, pendant le retrait total de la couche 78 et le retrait de l'isolant 50 sous l'élément 58, les couches de protection 68 et 74 sont attaquées, mais seulement partiellement et après libération de l'élément 58 quelques nanomètres d'épaisseur des couches 68 et 74 restent en place. Cela permet de minimiser l'impact des couches de protection sur l'élément résonant 58.

On notera également qu'en relation avec la figure 5D, on a considéré que les couches de protection 68 et 74 sont retirées totalement des tranchées 60. Ces couches de protection 68 et 74 peuvent toutefois n'être retirées que partiellement de façon à découvrir seulement partiellement l'isolant 50 au fond des tranchées 60.

Des modes de réalisation particuliers de la présente invention ont été décrits. Diverses variantes et modifications apparaîtront à l'homme de l'art. Ainsi, l'homme de l'art comprendra que la présente invention a été décrite dans le cas d'une technologie silicium. Toutefois, la couche 54 peut être réalisée en un autre matériau semiconducteur monocristallin ou polycristallin. En particulier, la couche 54 peut être une couche contrainte de silicium-germanium, une couche de germanium ou de tout autre matériau ou alliage semiconducteur tel que de l'arséniure de gallium. La couche 54 peut également être en un matériau semiconducteur à large bande interdite tel que du carbure de silicium (SiC) ou du carbone diamant. En outre, on a considéré précédemment que le résonateur est formé dans la couche mince d'un substrat sur isolant. Toutefois, le résonateur peut être formé dans un substrat massif.

Le résonateur peut également être formé dans un matériau non semiconducteur.

Lorsque des dimensions ont été indiquées, elles l'ont été dans le cadre d'une filière technologique donnée. L'homme de l'art saura adapter les dimensions des différents éléments en fonction des contraintes de fabrication.

L'homme de l'art saura également à partir des règles de dessins énoncées précédemment former des colonnes selon la présente invention dans tout type de résonateur quelle que soit la forme du corps semiconducteur et ses dimensions.

L'homme de l'art saura également modifier la structure de l'élément résonant en fonction d'une application donnée. De même, les modes d'ancrage des éléments résonants peuvent être modifiés. Ainsi, la plaque 30 de la figure 3 a été décrite comme étant fixée par quatre bras 32. Toutefois, la plaque 30 peut n'être fixée qu'à un unique bras ou posée sur un ancrage central solidaire du centre de la plaque 30.

En outre, l'homme de l'art saura adapter les matériaux utilisés à une filière de fabrication donnée.

De plus, la présente invention a été décrite appliquée aux résonateurs à ondes de volume. Toutefois, la formation dans le corps d'un microsystème de colonnes d'un matériau ayant un coefficient de température du module de Young du signe opposé à celui du corps peut être utilisée dans tous les autres types de résonateurs tels que des résonateurs à mode de flexion et de façon plus générale dans tout type de microsystèmes.

## Revendications

1. Résonateur comprenant un élément résonant (20 ; 30 ; 40 ; 58) comportant un corps (21 ; 31 ; 41 ; 54) et des colonnes (24 ; 34 ; 44 ; 70) d'un matériau (66) ayant un module d'Young (E) dont le coefficient de température (TCE) est d'un signe opposé à celui du corps.

2. Résonateur selon la revendication 1, dans lequel le résonateur est un résonateur à ondes de volume.

3. Résonateur selon la revendication 1 ou 2, dans lequel les colonnes (24 ; 34 ; 44 ; 70) s'étendent orthogonalement à la direction de vibration des ondes de volume.

4. Résonateur selon la revendication 1 ou 2, dans lequel les colonnes (24 ; 34 ; 44 ; 70) sont réparties dans l'élément (20 ; 30 ; 40 ; 58) selon la ou les directions d'extension/compression de l'élément.

5. Résonateur selon la revendication 1 ou 2, dans lequel une partie centrale (71) de l'élément (20 ; 30 ; 40 ; 58) est dépourvue de colonnes (24 ; 34 ; 44 ; 70).

6. Résonateur selon la revendication 1 ou 2, dans lequel une partie périphérique de l'élément (20 ; 30 ; 40 ; 58) est dépourvue de colonnes (24 ; 34 ; 44 ; 70).

7. Résonateur selon la revendication 1 ou 2, dans lequel les colonnes (24 ; 34 ; 44 ; 70) sont présentes dans l'élément (20 ; 30 ; 40 ; 58) dans une proportion comprise entre 10 et 60 % en volume.

8. Résonateur selon la revendication 7, dans lequel les colonnes (24 ; 34 ; 44 ; 70) sont présentes dans l'élément (20 ; 30 ; 40 ; 58) dans une proportion de 40 % en volume.

9. Résonateur selon la revendication 1 ou 2, dans lequel le corps (21 ; 31 ; 41 ; 54) est en silicium, en silicium-germanium, en arséniure de gallium, en carbure de silicium ou en carbone diamant.

10. Résonateur selon la revendication 1 ou 2, dans lequel le matériau (66) constituant les colonnes (24 ; 34 ; 44 ; 70) est de l'oxyde de silicium SiO₂), de l'oxyde d'aluminium (Al₂O₃) ou un oxynitrure de silicium (SiON).

11. Procédé de formation d'un résonateur dans un substrat (54), **caractérisé en ce qu'**il comprend une étape de formation, dans une partie du substrat destinée à constituer un élément résonant (58), de colonnes (70) en un matériau (66) dont le module d'Young (E) a un coefficient de température (TCE) du signe opposé à celui du substrat.

12. Procédé selon la revendication 11, dans lequel la formation des colonnes (70) comprend successivement :
former des ouvertures (62) dans toute l'épaisseur de la partie du substrat (54) destinée à constituer l'élément résonant (58) ; et
déposer dans les ouvertures un matériau (66) ayant un coefficient de température (TCE) du module d'Young (E) du signe opposé à celui du matériau constituant le substrat.

13. Procédé selon la revendication 11 ou 12, dans lequel le substrat (54) est un substrat (54) sur isolant (50) et dans lequel sont déposée :
avant le dépôt du matériau (66) ayant un coefficient de température (TCE) du module d'Young (E) du signe opposé à celui du matériau constituant le substrat (54), au moins au fond des ouvertures (62), une couche mince (68) d'un premier matériau gravable sélectivement par rapport à l'isolant (50) du substrat sur isolant ; et
après le dépôt dans les ouvertures du matériau ayant un coefficient de température du module d'Young du signe opposé à celui du matériau constituant le substrat, une couche (74) d'un second matériau gravable sélectivement par rapport audit isolant du substrat sur isolant.

## Claims

1. A resonator comprising a resonant element (20; 30; 40; 58) comprising a bulk (21; 31; 41; 54) and columns (24; 34; 44; 70) of a material (66) having a Young's modulus (E) with a temperature coefficient (TCE) having a sign opposite to that of the bulk.

2. The resonator of claim 1, wherein the resonator is a bulk mode resonator.

3. The resonator of claim 1 or 2, wherein the columns (24; 34; 44; 70) extend perpendicularly to the vibration direction of the bulk waves.

4. The resonator of claim 1 or 2, wherein the columns (24; 34; 44; 70) are distributed in the element (20; 30; 40; 58) along the direction(s) of expansion/compression of the element.

5. The resonator of claim 1 or 2, wherein a central portion (71) of the element (20; 30; 40; 58) is without columns (24; 34; 44; 70).

6. The resonator of claim 1 or 2, wherein a peripheral portion of the element (20; 30; 40; 58) is without columns (24; 34; 44; 70).

7. The resonator of claim 1 or 2, wherein the columns (24; 34; 44; 70) are present in the element (20; 30; 40; 58) in a proportion ranging between 10 and 60% by volume.

8. The resonator of claim 7, wherein the columns (24; 34; 44; 70) are present in the element (20; 30; 40; 58) in a proportion of 40% by volume.

9. The resonator of claim 1 or 2, wherein the bulk (21; 31; 41; 54) is made of silicon, of silicon-germanium, of gallium arsenide, of silicon carbide, or of diamond carbon.

10. The resonator of claim 1 or 2, wherein the material (66) forming the columns (24; 34; 44; 70) is silicon oxide (SiO₂), aluminum oxide (Al₂O₃), or a silicon oxynitride (SiON).

11. A method for forming a resonator in a substrate (54), comprising a step of forming, in a portion of the substrate intended to form a resonant element (58), columns (70) of a material (66) having a Young's modulus (E) with a temperature coefficient (TCE) of a sign opposite to that of the substrate.

12. The method of claim 11, wherein the forming of the columns (70) comprises the successive steps of:
forming openings (62) across the entire thickness of the substrate portion (54) intended to form the resonant element (58); and
depositing in the openings a material (66) having a temperature coefficient (TCE) of its Young's modulus (E) of a sign opposite to that of the material forming the substrate.

13. The method of claim 11 or 12, wherein the substrate (54) is a substrate (54) on insulator (50) and wherein the following depositions are performed:
before the deposition of the material (66) having a temperature coefficient (TCE) of its Young's modulus (E) of a sign opposite to that of the material forming the substrate (54), at least at the bottom of the openings (62), that of a thin layer (68) of a first material selectively etchable over the insulator (50) of the substrate on insulator; and
after the deposition in the openings of the material having a temperature coefficient of Young's modulus of a sign opposite to that of the material forming the substrate, that of a layer (74) of a second material selectively etchable over said insulator of the substrate on insulator.

## Patentansprüche

1. Ein Resonator, der Folgendes aufweist: ein Resonanzelement (20; 30; 40; 58), welches einen Körper (21; 31; 41; 54) und Säulen (24; 34; 44; 70) aus einem Material (66) mit einem Youngschen Modul (E) aufweist, mit einem Temperaturkoeffizienten (TCE) mit einem Vorzeichen entgegengesetzt zu dem des Körpers.

2. Resonator nach Anspruch 1, wobei der Resonator ein Resonator mit Körperwellen ist.

3. Resonator nach Anspruch 1 oder 2, wobei die Säulen (24; 34; 44; 70) sich senkrecht zu der Schwingungsrichtung der Körperwellen erstrecken.

4. Resonator nach Anspruch 1 oder 2, wobei die Säulen (24; 34; 44; 70) in dem Element (20; 30; 40; 58) entlang der oder den Richtung(en) zu der Ausdehnung/Kompression des Elements verteilt sind.

5. Resonator nach Anspruch 1 oder 2, wobei ein Mittelteil (71) des Elements (20; 30; 40; 58) ohne Säulen (24; 34; 44; 70) ausgebildet ist.

6. Resonator nach Anspruch 1 oder 2, wobei ein Umfangsteil des Elements (20; 30; 40; 58) ohne Säulen (24; 34; 44; 70) ausgebildet ist.

7. Resonator nach Anspruch 1 oder 2, wobei die Säulen (24; 34; 44; 70) in dem Element (20; 30; 40; 58) in einer Proportion im Bereich zwischen 10 und 60 Volumenprozent vorhanden sind.

8. Resonator nach Anspruch 7, wobei die Säulen (24; 34; 44; 70) in dem Element (20; 30; 40; 58) in einer Proportion von 40 Volumenprozent vorhanden sind.

9. Resonator nach Anspruch 1 oder 2, wobei der Körper (21; 31; 41; 54) hergestellt ist aus Silizium, aus Silizium-Germanium, aus Galliumarsenit, aus Siliziumcarbid oder aus Diamantkohlenstoff.

10. Resonator nach Anspruch 1 oder 2, wobei das Material (66), welches die Säulen (24; 34; 44; 70) bildet Siliziumoxid (SiO₂), Aluminiumoxid (Al₂O₃) oder ein Siliziumoxydnitrid (SiON) ist.

11. Verfahren zur Herstellung oder Formung eines Resonators in einem Substrat (54), wobei folgendes vorgesehen ist: ein Schritt des Formens, in einem Teil des Substrats, vorgesehen zur Bildung eines Resonanzelements (58) von Säulen (70) aus einem Material (66) mit einem Youngschen Modul (E) mit einem Temperaturkoeffizienten (TCE) eines Vorzeichens entgegengesetzt zu dem des Substrats.

12. Verfahren nach Anspruch 11, wobei das Formen der Säulen (70) die aufeinanderfolgenden Schritte aufweist: Formen oder Bilden von Öffnungen (62) über die gesamte Dicke des Substratteils (54) hinweg, und zwar des Substratsteils der dazu vorgesehen ist, das Resonanzelement (58) zu bilden; und
Abscheiden in den Öffnungen eines Materials (66) mit einem Temperaturkoeffizienten (TCE) seines Youngschen Moduls (E) mit einem entgegengesetzten Vorzeichen zu dem des das Substrat bildenden Materials.

13. Verfahren nach Anspruch 11 oder 12, wobei das Substrat (54) ein Substrat (54) auf einen Isolator (50) ist und wobei die folgenden Abscheidungen ausgeführt werden:
Abscheiden einer dünnen Schicht (68) eines ersten Materials, welches selektiv ätzbar ist, über dem Isolator (50) des Substrats auf dem Isolator,
und zwar vor der Abscheidung des Materials (66) mit einem Temperaturkoeffizienten (TCE) seines Youngschen Moduls (E) mit einem Vorzeichen entgegengesetzt zu dem des das Substrat (54) bildenden Materials mindestens an dem Boden der Öffnungen (62), und
Abscheiden einer Schicht (74) eines zweiten selektiv ätzbaren Materials über dem Isolator des Substrats auf dem Isolator,
und zwar nach der Abscheidung in den Öffnungen des Materials mit einem Temperaturkoeffizienten des Youngschen Moduls mit einem Vorzeichen entgegengesetzt zu dem des Materials, welches das Substrat bildet.
